# EUROPEAN PATENT APPLICATION

(11) **EP 2 787 538 A1**
(43) Date of publication of application: **08.10.2014**
(21) Application number: 11876652.6
(22) Date of filing: 28.11.2011
(51) Int. Cl.: H01L 31/042, H01L 31/18, H01L 51/46, H01L 51/48

(54) **POLYMER SOLAR CELL DEVICE AND METHOD FOR PREPARING SAME**

(71) Applicant: Ocean's King Lighting Science & Technology Co., Ltd., Nanhai Rd., Nanshan Shenzhen, Guangdong 518054 (CN); Shenzhen Ocean's King Lighting Engineering Co. Ltd., Guangdong 518054 (CN)
(72) Inventor: ZHOU, Mingjie, Shenzhen Guangdong 518054 (CN); WANG, Ping, Shenzhen Guangdong 518054 (CN); CHEN, Jixing, Shenzhen Guangdong 518054 (CN)
(74) Representative: Michalski Hüttermann & Partner Patentanwälte mbB
(86) International application number: PCT/CN2011/083019
(87) International publication number: WO 2013/078581

(57) **Abstract**

Provided are a polymer solar cell (100) and a method for preparing the same. The solar cell (100) comprises the following structures: a conductive anode substrate (10), a hole buffer layer (20), an active layer (30), an electron transportation layer (40) and a cathode (50); and the material for the electron transportation layer (40) is an electron transportation material doped with a cerium salt and metal particles. The solar cell (100) effectively increases the rate of electron transportation, and decreases the potential barrier between the electron transportation layer (40) and the cathode (50).

## Description

### FIELD OF THE INVENTION

The present disclosure relates to a field of solar cell, and more particularly relates to a polymer solar cell device and a method for preparing the same.

### BACKGROUND OF THE INVENTION

In 1982, Weinberger et al. researched the photovoltaic properties of polyacetylene and prepared the first true sense of solar cell, while the energy conversion efficiency of the solar cell is very low (10⁻³%). Subsequently, Glenis et al. prepared a variety of solar cells of polythiophene, but these solar cells had problems of very low open circuit voltage and photoelectric conversion efficiency. Until 1986, C.W.Tang et al. introduced the p-type semiconductor and the n-type semiconductor into devices of bilayer structure for the first time, the level of the photocurrent had been improved greatly, and the organic polymer solar cells had flourished since this work which is regarded as a milestone.

In 1992, Sariciftci et al. found that there was a phenomenon of rapid light-induced electron transfer in the composite system of 2 - methoxy-5 - (2 - ethyl - hexyloxy) -1,4 - styrene (MEH-PPV) and C60 derivatives, which aroused great interest. In 1995, Yu et al. prepared an organic polymer bulk-heterojunction solar cell by mixing MEH-PPV and C60 derivatives PCBM as an active layer. The energy conversion efficiency of the device was 2.9% under the monochromatic light of 20mW/cm² 430nm, this was the first bulk-heterojunction solar cell based on polymer materials and PCBM acceptor, and the concept of composite membrane interpenetrating with network structure was proposed. So far the application of the bulk-heterojunction structure in the polymer solar cell has been rapidly developed; this structure has been widely used in the organic polymer solar cell currently.

The working principle of the polymer solar cell mainly includes four parts: (1) the formation of light excitation and excitons; (2) the diffusion of the excitons; (3) the splitting of the excitons; (4) the transmission and collection of the charges. First, the conjugated polymer absorbs photons under the incident light, the electrons transit from the highest occupied orbital (HOMO) to the lowest empty track (LUMO) to form the excitons; the excitons diffuse to the intersurface of the donor/ acceptor under the influence of the built-in electric field and separate into free electrons and holes, and the electrons transfer in the receptor and are collected by the cathode, the holes are collected by the anode via the donor, thereby generating photocurrent. Accordingly, an effective photoelectric conversion process is formed.

The conventional polymer solar cell has a structure of conductive anode/hole buffer layer/active layer /electron buffer layer /cathode. While the electron buffer layer is usually made of lithium fluoride (LiF) with a much small thickness of about 0.7nm, which can help to improve the electron injecting ability. However, if the thickness of this material is too great (more than 1nm), the series resistance of the device will rise steeply, and most of the voltage falls within this region, thus ultimately affecting the photoelectric conversion efficiency; while if the thickness is too small, it will result in poor film formation, cause electron traps, lead to electronic quenching, and ultimately affect the energy conversion efficiency; thus a severer control of the thickness of the buffer layer is needed, and the production difficulty is increased. In the solar cells, the electron transport rate is often lower than the hole transport rate with two orders of magnitude, the electron transport rate already becomes an important reason for restricting the development of solar cells.

### SUMMARY OF THE INVENTION

Accordingly, it is necessary to provide a polymer solar cell device which is capable of improving the electron transport rate.

A polymer solar cell device includes a conductive anode substrate, a hole buffer layer, an active layer, an electron transporting layer, and a cathode, which are laminated in that order. The electron transporting layer is made of electron transporting material doped with cesium salt and metal particle. The metal particle has a particle size of from 1nm to 50nm; the metal particle is made of a material selected from the group consisting of aluminum, silver, gold, and platinum.

Preferably, a mass ratio of the cesium salt to the electron transporting layer is in a range of from 5% to 20%.

Preferably, a mass ratio of the metal particle to the electron transporting layer is in a range of from 0.5% to 5%.

Preferably, the electron transporting layer is made of a material selected from the group consisting of 2-(4- biphenyl)-5-(4- tert-butyl) phenyl -1,3,4- oxadiazole; 4,7- diphenyl -1,10- phenanthroline; 1,2,4- triazole derivant; and N- aryl benzimidazole.

Preferably, the cesium salt is selected from the group consisting of cesium carbonate, cesium azide, cesium fluoride, and cesium chloride.

Preferably, a thickness of the electron transporting layer is in a range of from 5nm to 40nm.

Preferably, the hole buffer layer is made of a mixture of poly 3,4 - ethylenedioxythiophene and polystyrene sulfonate with a mass ratio of 2:1 to 6:1.

Preferably, the active layer is made of a mixture of poly (3-hexylthiophene) and butyrate derivative of fullerene with a mass ratio of 1:0.8 to 1:1;
or, the active layer is made of a mixture of poly [2 - methoxy-5 - (3,7 - dimethyloctyl)oxy) phenylene vinylene] and butyrate derivative of fullerene with a mass ratio of 1:1 to 1:4;
or, the active layer is made of a mixture of poly [2 - methoxy-5-(2'- vinyl - hexyloxy) poly phenylene vinylene] and butyrate derivative of fullerene with a mass ratio of 1:1 to 1:4.

Preferably, the conductive anode substrate is made of a material selected from the group consisting of indium tin oxide glass, fluorine-doped tin oxide glass, aluminum -doped zinc oxide glass, and indium-doped zinc oxide glass;
the cathode is made of a material selected from the group consisting of aluminum, silver, gold, and platinum.

A method for preparing a polymer solar cell device includes steps of:
preprocessing a conductive anode substrate;
forming a hole buffer layer on the conductive anode substrate by spin-coating;
forming an active layer on the hole buffer layer by spin-coating;
depositing an electron transporting material doped with cesium salt and metal particle on the active layer to form an electron transporting layer; and
forming a cathode on the electron transporting layer, and obtaining the polymer solar cell device.

In the polymer solar cell device, the electron transporting layer is made of electron transporting material doped with cesium salt and metal particle. An n-doping is formed by doping cesium salt to the electron transporting material, which improves the electron transport rate effectively, and the energy band between the electron transporting layer and the active layer is bended, the injection barrier of the electrons on this interface is reduced; it is conducive to the injection of the electrons. Furthermore, the barrier between the electron transporting layer and the cathode is reduced due to the doping of metal particle; it is conducive to the collection of the electrons injected in the electron; thus an effective photoelectric conversion is formed. Further still, the film quality of the electron transporting layer formed by ternary doping is improved greatly due to the presence of the metal particle, the roughness of the film is reduced, the film is much more smoother; thus reducing the probability of the generation of the electron traps in the electron transport, and it is conducive to the transport of electrons, the energy conversion efficiency of the polymer solar cell device is finally improved.

### BRIEF DESCRIPTION OF THE DRAWINGS

FIG. 1 is a schematic, cross-sectional view of an embodiment of a polymer solar cell device;
FIG. 2 is a flow chart of an embodiment of a method of preparing the polymer solar cell device shown in FIG. 1;and
FIG. 3 is a graph illustrating a relationship of current density and voltage between the conventional polymer solar cell device and the polymer solar cell device of Example 1.

### DETAILED DESCRIPTION OF THE EMBODIMENTS

A more detailed description of the polymer solar cell device and a method of preparing the polymer solar cell device will be illustrated by reference to specific embodiments and drawings.

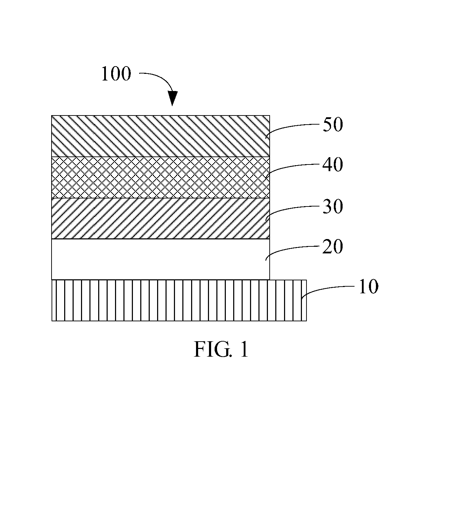

Referring to FIG. 1, an embodiment of a polymer solar cell device 100 includes a conductive anode substrate 10, a hole buffer layer 20, an active layer 30, an electron transporting layer 40, and a cathode 50, which are laminated in that order.

The conductive anode substrate 10 is made of a material selected from the group consisting of indium tin oxide glass (ITO), fluorine-doped tin oxide glass (FTO), aluminum-doped zinc oxide glass (AZO), and indium-doped zinc oxide glass (IZO).

The hole buffer layer 20 is made of a mixture of poly 3,4 - ethylenedioxythiophene (PEDOT) and polystyrene sulfonate (PSS) with a mass ratio of 2:1 to 6:1. A thickness of the hole buffer layer 20 is controlled to be in a range of from 20nm to 80nm. The hole buffer layer 20 can be formed by following steps: a solution of poly 3,4 - ethylenedioxythiophene (PEDOT) and polystyrene sulfonate (PSS) is spin-coated on the conductive anode substrate 10, a mass ratio of PEDOT to PSS is in a range of from 2:1 to 6:1, a mass percent of the solution is in a range of from 1% to 5%; and then the solution is dried at a temperature from 100°C to 200°C for 15 minutes to 60 minutes. Preferably, a solution of PEDOT and PSS is spin-coated, the mass ratio of PEDOT to PSS is 6:1, the mass percent of the solution is 1.3%, and then dried at a temperature of 200°C for 30 minutes. The thickness of the hole buffer layer is 40nm.

The active layer 30 is made of a mixture using butyrate derivatives of fullerene (PCBM) as acceptor; the thickness of the active layer 30 can be in a range of from 80nm to 300nm.

Specifically, the active layer 30 is made of a mixture composed of poly (3-hexylthiophene) (P3HT) and butyrate derivative of fullerene (PCBM) with a mass ratio of 1:0.8 to 1:1.

Or, the active layer 30 is made of a mixture composed of poly [2-methoxy-5 - (3,7 - dimethyloctyl)oxy) phenylenevinylene] (MDMO-PPV)and butyrate derivative of fullerene (PCBM) with a mass ratio of 1:1 to 1:4.

Or, the active layer is made of a mixture composed of poly [2 - methoxy-5-(2'- vinyl - hexyloxy) poly phenylenevinylene] (MEH-PPV) and butyrate derivative of fullerene (PCBM) with a mass ratio of 1:1 to 1:4.

Preferably, the active layer 30 is made composed of MEH-PPV: PCBM with a mass ratio of 1:3. The thickness of the active layer 30 is 200nm.

The electron transporting layer 40 is made of electron transporting material doped with cesium salt and metal particle.

A mass ratio of the cesium salt to the electron transporting layer is in a range of from 5% to 20%.

The cesium salt can be selected from the group consisting of cesium carbonate, cesium azide, cesium fluoride, and cesium chloride.

A mass ratio of the metal particle to the electron transporting layer is in a range of from 0.5% to 5%.

A particle size of the metal particle is in a range of from 1nm to 50nm. Preferably, the particle size of the metal particle is in a range of from 10nm to 30nm.

The metal particle is made of metal with a high conductivity, a work function beyond 4.2eV, and a melting point below 2000°C. When a film with a thickness 10nm is made of the metal, the visible light transmittance of the metal is needed to be greater than 90%. Specifically, the metal can be selected from the group consisting of the aluminum (Al), silver (Ag), gold (Au), and platinum (Pt).

The electron transporting material can be selected from the group consisting of 2-(4- biphenyl)-5-(4- tert - butyl) phenyl -1,3,4- oxadiazole (PBD); 4,7- diphenyl -1,10- phenanthroline (Bphen); 1,2,4- triazole derivant (such as TAZ); and N- aryl benzimidazole (TPBI).

The thickness of the electron transporting layer 40 is in a range of from 5nm to 40nm.

The cathode 50 is made of material selected from the group consisting of aluminum (Al), silver (Ag), gold (Au), and platinum (Pt).

The thickness of the cathode 50 is in a range of from 80nm to 250nm.

Preferably, the cathode 50 is made of Al; the thickness of the cathode 50 is 150nm.

In the polymer solar cell device 100, the electron transporting layer 40 is made of electron transporting material doped with cesium salt and metal particle. An n-doping is formed by doping cesium salt to the electron transporting material, which improves the electron transport rate effectively, and the energy band between the electron transporting layer 40 and the active layer 30 is bend, the injection barrier of the electrons on this interface is reduced, it is conducive to the injection of the electrons. Furthermore, the electron transporting layer 40 is also doped with metal particle, which reduces the barrier between the electron transporting layer 40 and the cathode 50, it is conducive to collection of the electrons injected in the electron; thus an effective photoelectric conversion is obtained. Further still, the film quality of the electron transporting layer 40 formed by ternary doping is improved greatly due to the presence of the metal particle, the roughness of the film is reduced, the film is much more smoother, thus reducing the probability of the generation of the electron traps of the electron transport, and it is conducive to the transport of electrons; the energy conversion efficiency of the polymer solar cell device 100 is finally improved.

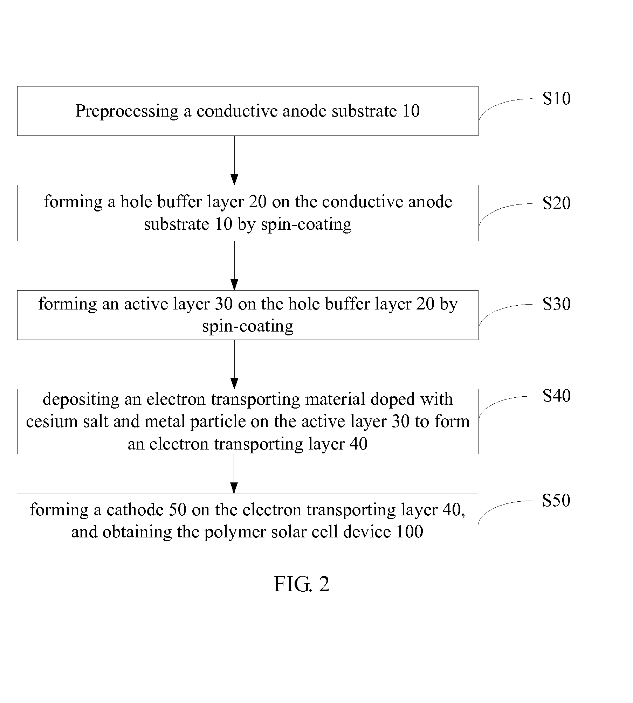

Referring to FIG. 2, an embodiment of a method for preparing a polymer solar cell device 100 is provided, which includes the steps of:

Step S10, a conductive anode substrate 10 is preprocessed.

The conductive anode substrate 10 is made of material selected from the group consisting of indium tin oxide glass (ITO), fluorine-doped tin oxide glass (FTO), aluminum-doped zinc oxide glass (AZO), and indium-doped zinc oxide glass (IZO).

The pretreatment process includes the following steps: the conductive anode substrate 10 is cleaned, then the conductive anode substrate 10 is treated with oxygen plasma or a UV-ozone.

Specifically, the conductive anode substrate 10 is photoetched and cut into pieces with required size, the conductive anode substrate 10 is then treated using ultrasonic sequentially in detergent, deionized water, acetone, ethanol, and isopropyl alcohol each for 15 minutes to remove organic pollutants on the surface of the glass. The conductive anode substrate 10 is surface-treated using oxygen plasma for 5 minutes to 15 minutes after cleaning; the power is 10W to 50W. The UV-ozone treatment can be performed for 5minutes to 20minutes.

Step S20, a hole buffer layer 20 is formed on the surface of the conductive anode substrate 10 by spin-coating.

The hole buffer layer 20 is made of a mixture of poly 3,4-ethylenedioxythiophene (PEDOT) and polystyrene sulfonate (PSS) with a mass ratio of 2:1 to 6:1. A solution of poly 3,4 -ethylenedioxythiophene (PEDOT) and polystyrene sulfonate (PSS) is spin-coated on the conductive anode substrate 10, a mass ratio of PEDOT to PSS is in a range of from 2:1 to 6:1, a mass percent of the solution is in a range of from 1% to 5%, and then dried at a temperature from 100°C to 200°C for 15minutes to 60 minutes.

The thickness of the hole buffer layer 20 is in a range of from 20nm to 80nm.

Preferably, the solution of PEDOT and PSS is spin-coated, the mass ratio of PEDOT to PSS is 6:1, the mass percent of the solution is 1.3%; and then the solution is dried at a temperature of 200°C for 30 minutes. The thickness of the hole buffer layer 20 is 40nm.

Step S30, an active layer 30 is formed on the hole buffer layer 20 by spin-coating.

An active material is dissolved in an organic solvent to form an active material solution. Under an atmosphere of the protective gas, the active material solution is spin-coated on the surface of the hole buffer layer 20, and then dried to obtain the active layer 30.

In the active material solution, the total concentration of the active material is in a range of from 8mg/L to 30mg/L.

When the active material solution is spin-coated to form the active layer 30, the active material is a system using butyrate derivative of fullerene (PCBM) as an acceptor.

Specifically, the active material can be a mixture composed of poly (3-hexylthiophene) and butyrate derivative of fullerene (PCBM) with a mass ratio of 1:0.8 to 1:1

Or, the active material can be a mixture composed of poly [2 - methoxy-5-(3,7 - dimethyloctyl)oxy) phenylene vinylene] (MDMO-PPV)and butyrate derivativeof fullerene (PCBM) with a mass ratio of 1:1 to 1:4.

Or, the active material can be a mixture composed of poly [2 - methoxy-5-(2'- vinyl - hexyloxy) poly phenylene vinylene] (MEH-PPV) and butyrate derivativeof fullerene (PCBM) with a mass ratio of 1:1 to 1:4.

The organic solvent can be one or two selected from the group consisting of toluene, xylene, chlorobenzene, and chloroform.

Preferably, the active material solution can be a chlorobenzene solution of MEH-PPV and PCBM with a mass ratio of 1:3 and a total concentration of 24mg/mL.

The protective gas atmosphere can be a nitrogen atmosphere or an inert gas atmosphere.

The thickness of the active layer 30 can be in a range of from 80nm to 300nm. Preferably, the thickness of the active layer 30 is 200nm.

The active layer 30 can be dried at a room temperature for 24 hours to 48 hours, or annealed at a temperature from 50°C to 100°C for 10minutes to 100mimutes. Preferably, the active layer 30 is annealed at a temperature 100°C for 45min.

Step S40, an electron transporting material doped with cesium salt and metal particle is deposited on the active layer 30 to form an electron transporting layer 40.

A mass ratio of the cesium salt to the electron transporting layer is in a range of from 5% to 20%.

The cesium salt is selected from the group consisting of cesium carbonate (Cs₂CO₃), cesium azide (CsN₃), cesium fluoride (CsF), and cesium chloride (CsCI).

A mass ratio of the metal particle to the electron transporting layer is in a range of from 0.5% to 5%.

The particle size of the metal particle is in a range of from 1nm to 50nm. Preferably, the particle size of the metal particle is in a range of from 10m to 30nm.

The metal particle is made of metal with a high conductivity, a work function beyond 4.2eV, and a melting point below 2000°C. When a film with a thickness 10nm is made of the metal, the visible light transmittance of the metal is needed to be greater than 90%. Specifically, the electron transporting material can be selected from the group consisting of 2-(4- biphenyl)-5-(4- tert - butyl) phenyl -1,3,4-oxadiazole (PBD); 4,7- diphenyl -1,10- phenanthroline (Bphen); 1,2,4- triazole derivant (such as TAZ); and N- aryl benzimidazole (TPBI).

The thickness of the electron transporting layer 40 is in a range of 5nm to 40nm.

Step S50, a cathode 50 is formed on the electron transporting layer 40; and the polymer solar cell device 100 is obtained.

The cathode 50 is made of material selected from the group consisting of aluminum (Al), silver (Ag), gold(Au), and platinum (Pt).

The thickness of the cathode 50 is in a range of 80nm to 250nm.

Preferably, the cathode 50 is made of Al; the thickness of the cathode 50 is 150nm.

The specific examples are further described as follows:

The test instruments used in each example are: a high vacuum coating equipment (Shenyang scientific instruments Center Ltd. pressure<1×10⁻³Pa), a current-voltage tester (U.S. Keithly Corporation, Model: 2602), a 500W xenon lamp (Osram) combined with filter of AM 1.5 are used as white light source for simulating sunlight.

### EXAMPLE 1

The embodiment of the polymer solar cell device has a structure of ITO/(PEDOT:PSS)/ (MEH-PPV:PCBM)/ (Bhpen:Cs₂CO₃:Ag) /Al.

The preparation process of the polymer solar cell device is described as follows:

The ITO was photoetched and cut into pieces with required size, the ITO was then treated using ultrasonic sequentially in detergent, deionized water, acetone, ethanol, and isopropyl alcohol each for 15 minutes to remove organic pollutants on the surface of the glass. The ITO was treated with oxygen plasma for 5 minutes after cleaning; the power was 30W. A solution of PEDOT and PSS was spin-coated on the ITO, a mass ratio of PEDOT to PSS was 6:1, a mass percent of the solution was 1.3%; and then heated at a temperature of 200°C for 30minutes, a hole buffer layer with a thickness of 40nm was formed. Then, under a nitrogen atmosphere, a chlorobenzene solution of MEH-PPV and PCBM was spin-coated on the hole buffer layer, a mass ratio of MEH-PPV to PCBM was 1:3, a total concentration of the chlorobenzene solution was 24mg/mL, and then placed at a room temperature for 48 hours to form an active layer with a thickness of 200nm. Then, a material of Bhpen:Cs₂CO₃:Ag (Cs₂CO₃ and Ag were used as doping material, a mass ratio of Cs₂CO₃ was 10%, a particle size of Ag was 30nm, a mass ratio of Ag was 1%) was deposited to form an electron transporting layer with a thickness of 25nm. Finally, a cathode was formed by depositing, the cathode was made of Al, the thickness of that was 150nm, and a required polymer solar cell device was formed.

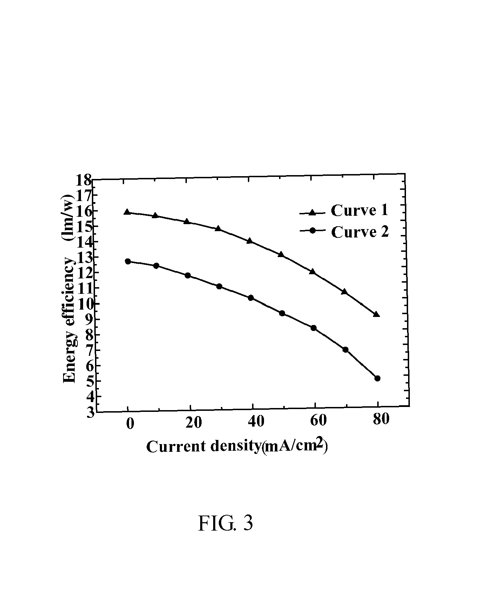

FIG. 3 was a graph illustrating a relationship of current density and voltage between the conventional polymer solar cell device and the polymer solar cell device of example 1.

Curve 1 was a graph illustrating a relationship of current density and voltage of the polymer solar cell device of example 1; curve 2 was a graph illustrating a relationship of current density and voltage of the conventional polymer solar cell device.

The difference between the polymer solar cell device of example 1 and the conventional polymer solar cell device was only about the electron transporting layer. The electron transporting layer of the conventional polymer solar cell device was made of LiF with a thickness of 0.7nm.

Referring to FIG. 3, the polymer solar cell device was subjected to a photocurrent test (in the atmosphere, with a light intensity of 100mW/cm² and an irradiation area of 0.09mm²); the specific data was shown as the following table.

| | Current density(mA cm⁻²) | voltage (V) | η (%) | fill factor |
|---|---|---|---|---|
| Curve 1 | 6.48 | 0.66 | 1.38 | 0.32 |
| Curve 2 | 5.21 | 0.63 | 1.02 | 0.31 |

It can be seen that, the current density of the conventional polymer solar cell device is 5.21mA/cm², while the current density of the polymer solar cell device of Example one is increased to 6.48 mA/cm². The results illustrate that the electron transferring rate of the polymer solar cell device is effectively improved by using a ternary doped electron transporting layer, which reduces the barriers between the active layer, the electron transporting layer, and the cathode; the efficiency of electron injection and electron transport is effectively increased; finally, the energy conversion efficiency of the device is improved. The energy conversion efficiency of conventional polymer solar cell device is 1.02%, while the energy conversion efficiency of the polymer solar cell device of Example one is 1.38%.

### EXAMPLE 2

The embodiment of the polymer solar cell device has a structure of IZO/(PEDOT:PSS)/ (MDMO-PPV:PCBM)/ (PBD:CsF:Al) /Ag.

The preparation process is described as follows:

The IZO was photoetched and cut into pieces with required size, the IZO was then treated using ultrasonic sequentially in detergent, deionized water, acetone, ethanol, and isopropyl alcohol each for 15 minutes to remove organic pollutants on the surface of the glass, respectively. The IZO was treated with oxygen plasma for 5 minutes after cleaning; the power was 30W. A solution of PEDOT and PSS was spin-coated on the IZO, a mass ratio of PEDOT to PSS was 2:1, a mass percent of the solution was 5%; and then heated at a temperature of 100°C for 60minutes, a hole buffer layer with a thickness of 20nm was formed. Then, under an argon atmosphere, an xylene solution of MEH-PPV and PCBM was spin-coated on the hole buffer layer, a mass ratio of MEH-PPV to PCBM was 1:4, a total concentration of the xylene solution was 8mg/mL, and annealed at a temperature of 200°C for 5min to form an active layer with a thickness of 300nm. Then, a material of PBD:CsF:Al (CsF and Al were used as doping material, a mass ratio of CsF was 20%, a particle size of Al was 10nm, a mass ratio of Al was 0.5%) was deposited to form an electron transporting layer with a thickness of 5nm. Finally, a cathode was formed by depositing, the cathode was made of Ag, the thickness of that was 80nm, and a required polymer solar cell device was formed.

### EXAMPLE 3

The embodiment of the polymer solar cell device has a structure of AZO/(PEDOT:PSS)/ (P3HT:PCBM)/ (TPBi: CsCl:Au) /Pt.

The preparation process is described as follows:

The AZO was photoetched and cut into pieces with required size, the AZO was then treated using ultrasonic sequentially in detergent, deionized water, acetone, ethanol, and isopropyl alcohol each for 15 minutes to remove organic pollutants on the surface of the glass, respectively. The AZO was treated with UV-ozone treatment for 15 minutes after cleaning. A solution of PEDOT and PSS was spin-coated on the AZO, a mass ratio of PEDOT to PSS was 4:1, a mass percent of the solution was 1%; and then heated at a temperature of 200°C for 15minutes, a hole buffer layer with a thickness of 80nm was formed. Then, under a helium atmosphere, an xylene solution of P3HT and PCBM was spin-coated on the hole buffer layer, a mass ratio of P3HT to PCBM was 1:0.8, a total concentration of the xylene solution was 30mg/mL, and annealed at a temperature of 100°C for 30 minutes to form an active layer with a thickness of 100nm. Then, a material of TPBi:CsCl:Au (CsCl and Au were used as doping material, a mass ratio of CsCl was 5%, a particle size of Au was 1nm, a mass ratio of Au was 5%) was deposited to form an electron transporting layer with a thickness of 40nm. Finally, a cathode was formed by depositing, the cathode was made of Pt, the thickness of that was 250nm, and a required polymer solar cell device was formed.

### EXAMPLE 4

The embodiment of the polymer solar cell device has a structure of FTO/(PEDOT:PSS)/ (P3HT:PCBM)/ (TAZ: CsN₃:Pt) /Au.

The preparation process is described as follows:

The FZO was photoetched and cut into pieces with required size, the FZO was then treated using ultrasonic sequentially in detergent, deionized water, acetone, ethanol, and isopropyl alcohol each for 15 minutes to remove organic pollutants on the surface of the glass, respectively. The FZO was treated with oxygen plasma for 5 minutes after cleaning; the power was 30W. A solution of PEDOT and PSS was spin-coated on the FZO, a mass ratio of PEDOT to PSS was 5:1, a mass percent of the solution was 2%; and then heated at a temperature of 100°C for 45minutes, a hole buffer layer with a thickness of 60nm was formed. Then, under a nitrogen atmosphere, a chlorobenzene solution of P3HT and PCBM was spin-coated on the hole buffer layer, a mass ratio of MEH-PPV to PCBM was 1:1, a total concentration of the chlorobenzene solution was 20mg/mL, and annealed at a temperature of 50°C for 10minutes to form an active layer with a thickness of 80nm. Then, a material of TAZ:CsN₃:Pt (CsN₃ and Pt were used as doping material, a mass ratio of CsN₃ was 10%, a particle size of Pt was 20nm, a mass ratio of Pt was 2%) was deposited to form an electron transporting layer with a thickness of 20nm. Finally, a cathode was formed by depositing, the cathode was made of Au, the thickness of that was 100nm, and a required polymer solar cell device was formed.

### EXAMPLE 5

The embodiment of the polymer solar cell device has a structure of IZO/(PEDOT:PSS)/ (MEH-PPV:PCBM)/ (Bphen: CsF:Ag) /Al.

The preparation process of the polymer solar cell device is described as follows:

The ITO was photoetched and cut into pieces with required size, the ITO was then treated using ultrasonic sequentially in detergent, deionized water, acetone, ethanol, and isopropyl alcohol each for 15 minutes to remove organic pollutants on the surface of the glass, respectively. The ITO was treated with oxygen plasma for 5 minutes after cleaning; the power was 30W. A solution of PEDOT and PSS was spin-coated on the ITO, a mass ratio of PEDOT to PSS was 6:1, a mass percent of the solution was 5%; and then heated at a temperature of 200°C for 15minutes, a hole buffer layer with a thickness of 40nm was formed. Then, under a nitrogen atmosphere, a mixed solution of chloroform and chlorobenzene of MEH-PPV and PCBM was spin-coated on the hole buffer layer, a mass ratio of MEH-PPV to PCBM was 1:2, a total concentration of the mixed solution was 16mg/mL, and annealed at a temperature of 150°C for 60minutes to form an active layer with a thickness of 160nm. Then, a material of Bhpen:CsF:Ag (CsF and Ag were used as doping material, a mass ratio of CsF was 15%, a particle size of Ag was 50nm, a mass ratio of Ag was 2%) was deposited to form an electron transporting layer with a thickness of 25nm. Finally, a cathode was formed by depositing, the cathode was made of Al, the thickness of that was 150nm, and a required polymer solar cell device was formed.

Although the invention has been described in language specific to structural features and/or methodological acts, it is to be understood that the invention defined in the appended claims is not necessarily limited to the specific features or acts described. Rather, the specific features and acts are disclosed as sample forms of implementing the claimed invention.

## Claims

1. A polymer solar cell device, comprising a conductive anode substrate, a hole buffer layer, an active layer, an electron transporting layer, and a cathode, which are laminated in that order;
wherein the electron transporting layer is made of electron transporting material doped with cesium salt and metal particle; the metal particle has a particle size in a range of from 1nm to 50nm, the metal particle is made of a material selected from the group consisting of aluminum, silver, gold, and platinum.

2. The polymer solar cell device according to claim 1, wherein a mass ratio of the cesium salt to the electron transporting layer is in a range of from 5% to 20%.

3. The polymer solar cell device according to claim 1, wherein a mass ratio of the metal particle to the electron transporting layer is in a range of from 0.5% to 5%.

4. The polymer solar cell device according to claim 1, wherein the electron transporting layer is made of a material selected from the group consisting of 2-(4- biphenyl )-5-(4-tert-butyl) phenyl -1,3,4- oxadiazole; 4,7- diphenyl -1,10- phenanthroline; 1,2,4- triazole derivant; and N- aryl benzimidazole.

5. The polymer solar cell device according to claim 1, wherein the cesium salt is selected from the group consisting of cesium carbonate, cesium azide, cesium fluoride, and cesium chloride.

6. The polymer solar cell device according to claim 1, wherein a thickness of the electron transporting layer is in a range of from 5nm to 40nm.

7. The polymer solar cell device according to claim 1, wherein the hole buffer layer is made of a mixture of poly 3,4 - ethylenedioxythiophene and polystyrene sulfonate with a mass ratio of 2:1 to 6:1.

8. The polymer solar cell device according to claim 1, wherein the active layer is made of a mixture of poly (3-hexylthiophene) and butyrate derivative of fullerene with a mass ratio of 1:0.8 to 1:1;
or, the active layer is made of a mixture of poly [2 - methoxy-5 - (3,7 - dimethyloctyl)oxy) phenylene vinylene] and butyrate derivative of fullerene with a mass ratio of 1:1 to 1:4; or, the active layer is made of a mixture of poly [2 - methoxy-5 - (2'- vinyl - hexyloxy) poly phenylene vinylene] and butyrate derivative of fullerene with a mass ratio of 1:1 to 1:4.

9. The polymer solar cell device according to claim 1, wherein the conductive anode substrate is made of a material selected from the group consisting of indium tin oxide glass, fluorine-doped tin oxide glass, aluminum -doped zinc oxide glass, and indium-doped zinc oxide glass;
the cathode is made of a material selected from the group consisting of aluminum, silver, gold, and platinum.

10. A method of preparing a polymer solar cell device, comprising the steps of:
preprocessing a conductive anode substrate;
forming a hole buffer layer on the conductive anode substrate by spin-coating;
forming an active layer on the hole buffer layer by spin-coating;
depositing an electron transporting material doped with cesium salt and metal particle on the active layer to form an electron transporting layer; and
forming a cathode on the electron transporting layer, and obtaining the polymer solar cell device.
